# EUROPEAN PATENT APPLICATION

(11) **EP 1 170 788 A2**
(43) Date of publication of application: **09.01.2002**
(21) Application number: 01810572.6
(22) Date of filing: 14.06.2001
(51) Int. Cl.: H01L 21/58, H01L 21/00

(54) **Method and apparatus for mounting semiconductor chips onto a flexible substrate**

(30) Priority: 03.07.2000 EP 00810577
(71) Applicant: Esec Trading S.A., 6330 Cham (CH)
(72) Inventor: Ulrich, René Josef, 6353 Weggis (CH)
(74) Representative: Falk, Urs, Dr.

(57) **Abstract**

The mounting of semiconductor chips (1) onto a flexible substrate (2) takes place in three steps: Firstly, at a dispensing station (3), adhesive (4) is applied to predetermined substrate sites (5) on the substrate (2). Then, at a bonding station (6), semiconductor chips (1) are placed onto the substrate sites (5). Finally, curing of the adhesive (4) takes place. In accordance with the invention, the substrate (2) is fixed onto a level support surface (10) by means of vacuum during the hardening of the adhesive (4).

## Description

The invention concerns a method and an apparatus for mounting semiconductor chips onto a flexible substrate.

In the semiconductor industry, apart from the proven metallic substrates, flexible substrates such as BGA® flextapes are increasingly being used. Furthermore, such flextapes are becoming increasingly thin and reach thicknesses of only 50µm. This leads to difficulties with the mounting of semiconductor chips which are manifested by irregular thickness of the adhesive between the semiconductor chip and the flextape, inclined (tilt) and incorrect position of the semiconductor chip. In addition, it can happen that, before finally hardening, the adhesive flows about, contracts, separates locally in various phases, etc., which can strongly impair the quality of the adhesive bond. Contamination of the bond pads can also result from this.

The object of the invention is to propose a method and a device with which flexible substrates can be equipped with semiconductor chips in reliable and high quality.

The invention is characterised in claim 1. Further developments of the invention result from the dependent claims.

Solving of the task is achieved in accordance with the invention in that the substrate is held flat on a level support surface at least during hardening of the adhesive preferably however during all critical phases of the mounting process.

With a first solution, the automatic assembly machine, a so-called die bonder, is equipped with a heating plate in order to harden the adhesive immediately after applying the semiconductor chip. The heating plate has channels or grooves on the support surface facing the substrate to which vacuum can be applied in order to hold the substrate flat until the adhesive has hardened. In addition, the automatic assembly machine is preferably equipped with a support plate which also has channels or grooves to which vacuum can be applied in order to suck the entire area of the substrate onto a level support surface during application of the adhesive and during placement of the semiconductor chip.

This solution is particularly suitable for the processing of so-called matrix substrates with which the substrate sites for the semiconductor chips are arranged next to each other on the substrate in blocks of n rows and m columns. Mounting of the semiconductor chips takes place as usual in three steps: In the first step, adhesive is applied to the substrate sites at a dispensing station. In the second step, the semiconductor chips are placed onto the substrate sites at a bonding station. In the third step, the adhesive is hardened. In order that sufficient time is available for the hardening of the adhesive, processing of such a matrix substrate takes place in blocks as follows: As soon as a block with its n x m substrate sites is completely equipped with semiconductor chips, the vacuum is released and the substrate is advanced in transport direction. At the same time, the support plate and heating plate are moved back in the opposite direction to the transport direction to a predetermined start position. Afterwards, vacuum is applied to the channels of the support plate as well as the heating plate so that the substrate lies flat and is fixed on the support plate and also on the heating plate. Subsequently, adhesive is applied to the next n x m substrate sites at the dispensing station and, at the bonding station, the substrate sites to which adhesive has already been applied are equipped column for column with semiconductor chips. When a column is fully equipped, then, without releasing the vacuum, the support plate and the heating plate are advanced together in transport direction for equipping the next column. The substrate therefore remains fixed on the support plate and the heating plate and is moved with them. After equipping the last column of a block, the next cycle begins in the way described by releasing the vacuum, advancing the substrate and returning the support plate and the heating plate.

Doubling or triplicating of the curing time can be achieved in that the heating plate is formed with two or three heating positions. In order that the throughput rate of the automatic assembly machine can be maintained relatively high, relatively fast setting adhesives must be used with this solution.

With certain applications, it suffices when the adhesive is only partially cured, eg, 80%. The remaining hardening then takes place in a subsequent process step, for example during wiring on a wire bonder.

With a second solution, the hardening of the adhesive does not take place on the automatic assembly machine, but in an oven. During the time spent in the oven, it is ensured that the substrate lies flat on a support. A plate with channels or grooves to which vacuum can be applied so that the substrate can be sucked on to it serves as the support. The plate itself can, but must not necessarily, be heated. With this solution, slowly setting adhesives can also be used.

The invention results in a great improvement in the mounting quality. Because the substrate is held flat during hardening of the adhesive, an adhesive layer of constant thickness is formed between the substrate and the semiconductor chip: During hardening, the adhesive can no longer bend the substrate. Furthermore, a greater homogeneity of the adhesive is achieved while with customary hardening, the different components of the adhesive can segregate, for example, into areas of a lot of silver and areas with little silver, or even voids can occur.

Furthermore, the lying flat of the substrate on the heating plate guarantees the reliable heat transfer from the heating plate to the adhesive. This is of great importance as the quality of the heat transfer has a decisive influence on the curing time necessary for the complete hardening of the adhesive.

In the following, embodiments of the invention are explained in more detail based on the drawing.

It is shown in:
- Fig. 1: a device for the mounting of semiconductor chips,
- Fig. 2: a support plate and a heating plate,
- Fig. 3: a substrate, and
- Figs. 4 and 5: an oven.

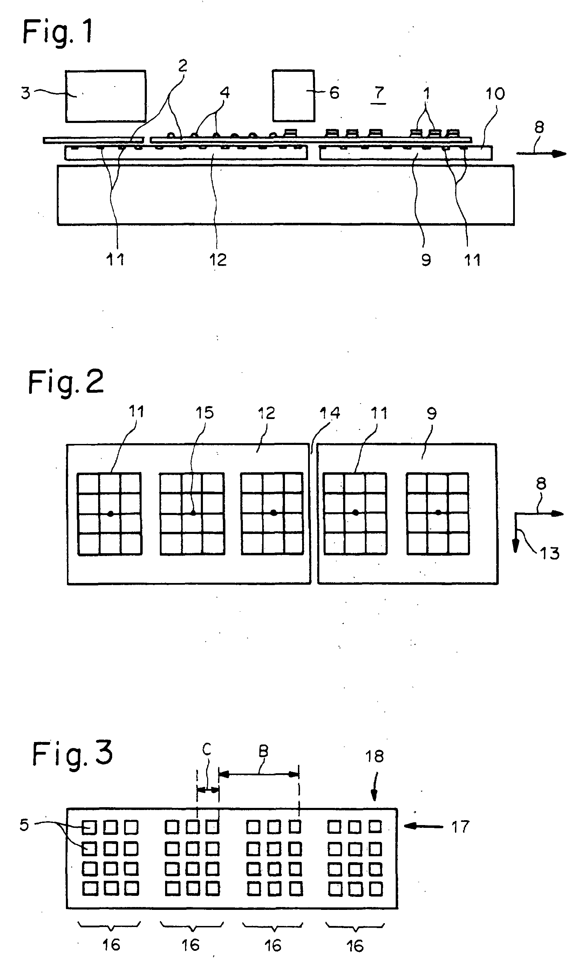

Fig. 1 shows a schematic presentation of a device for the mounting of semiconductor chips 1 onto a flexible substrate 2. The device has a dispensing station 3 for applying adhesive 4 to substrate sites 5 (Fig. 3) of the substrate 2, a bonding station 6 for equipping the substrate sites 5 with the semiconductor chips 1 and a curing station 7 for hardening the adhesive 4 which are arranged one after the other in transport direction 8 of the substrate 2. The curing station 7 comprises a movable heating plate 9 the support surface 10 of which facing the substrate 2 has channels 11 to which vacuum can be applied for sucking down the substrate 2. Furthermore, the mounting device comprises a support plate 12, movable together with the heating plate 9, which also has channels 11 to which vacuum can be applied for sucking down the substrate 2. Two drives are provided for moving the heating plate 9 and the support plate 12 in transport direction 8 as well as in a direction 13 (Fig. 2) at right angles to the transport direction 8.

Fig. 2 shows a plan view of the support plate 12 and the heating plate 9. Mechanically, the support plate 12 and the heating plate 9 are rigidly connected but are separated by means of a gap 14. In this way, it is avoided that significant heat is transferred from the heating plate 9 to the support plate 12 so that hardening of the adhesive 4 only begins when the substrate sites 5 are located on the heating plate 9. The channels 1 are connected to a vacuum source via drill holes 15. Position and length of the individual channels 11 are selected so that the substrate 2 can be sucked down over its whole area so that it rests absolutely flat on the support plate 12 or the heating plate 9. The heating plate 9 has two fields with channels 11 so that the adhesive 4 can be cured over two cycles.

Fig. 3 shows a plan view of the substrate 2. The substrate sites 5 are arranged in blocks 16 of m rows 17 and n columns 18. In the example shown, m=3 and n=4. The distance from column 18 to column 18 is marked with C, the distance from block 16 to block 16 with B.

In operation of the mounting device, the substrate sites 5 are processed in blocks: At the dispensing station 3, the adhesive 4 is applied to the substrate sites 5 of a first block 16. At the bonding station 6, the semiconductor chips 1 are placed onto the substrate sites 5 of a second block 16. In the curing station 7, the hardening of the adhesive 4 takes place for the substrate sites 5 of a third and fourth block 16. Depending on the instantaneous situation, the four blocks 16 belong to the same substrate 2 or to different substrates 2. The processing by blocks means that, during processing of the m ∗ n substrate sites 5 of a block 16, the substrate 2 remains continuously fixed to the support plate 12 and the heating plate 9. Only when a block 16 with its m ∗ n substrate sites 5 is completely equipped with semiconductor chips 1 is the vacuum released and the substrate 2 advanced in transport direction 8 by the distance B - (n-1) ∗ C. At the same time, the support plate 12 and the heating plate 9 are moved back by a distance (n-1) ∗ C against transport direction 8 to a predetermined start position. After this, vacuum is applied to the channels 11 of the support plate 12 as well as to those of the heating plate 9 so that the substrate 2 rests flat on and is fixed to the support plate 12 and the heating plate 9. Subsequently, adhesive 4 is applied to the substrate sites 5 of the next block 16 at the dispensing station 3 and, at the bonding station 6, semiconductor chips 1 are applied column 18 for column 18 to the substrate sites 5 which already have adhesive 4. When a column 18 is fully equipped, without releasing the vacuum, the support plate 12 and the heating plate 9 are advanced together in transport direction 8 by distance C for equipping the next column 18. In doing so, the substrate 2 remains fixed to the support plate 12 and the heating plate 9 and is moved with them. After equipping the last column 18 of a block 16, the next cycle begins in the way described by releasing the vacuum, advancing the substrate 2 by the distance B - (n-1) ∗ C and returning the support plate 12 and the heating plate 9 by the distance (n-1) ∗ C.

If the bonding station 6 always places the semiconductor chips 1 at a predetermined location, the support plate 12 and the heating plate 9 are also moved in direction 13, ie, orthogonal to the transport direction 8, for equipping the m substrate sites 5 lying within a column 18.

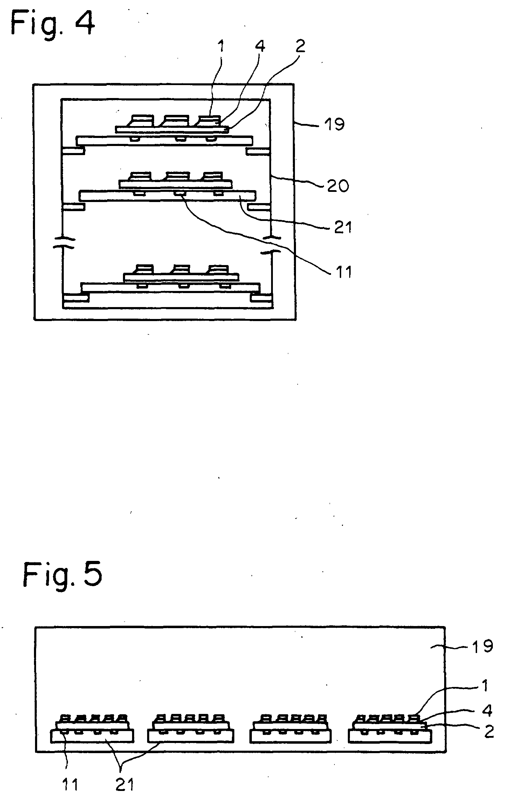

Fig. 4 shows a cross-section of an oven 19 for the curing of the adhesive 4. The oven 19 has a removable magazine 20 with numerous plates 21 which have channels 11 to which vacuum can be applied in order to suck down the substrate 2. The magazine 20 is loaded with the substrates 2 in a relatively cold condition outside the oven 9 and vacuum is applied to the channels 11 of its plates 21 so that the substrates 2 rest flat on the plates 21 before hardening starts.

Fig. 5 shows a cross-section of a further oven 19 which is formed as a continuous oven. The substrates 2 equipped with the semiconductor chips 1 are transported one after the other through the oven 19 in feed-through direction. The substrates 2 rest on plates 21 which have channels 11 to which vacuum can be applied in order to suck down the substrates 2 so that they rest flat on the plates 12.

## Claims

1. Method for mounting semiconductor chips (1) onto a flexible substrate (2), whereby at a dispensing station (3) adhesive (4) is applied to predetermined substrate sites (5) on the substrate (2), at a bonding station (6) the semiconductor chips (1) are placed on the substrate sites (5) and in a curing station (7) the adhesive (4) is cured, **characterised in that** during curing of the adhesive (4), the substrate (2) is fixed onto an even support surface (10) by means of vacuum.

2. Method according to claim 1, **characterised in that** the curing of the adhesive (4) takes place on a heating plate (9), located immediately after the bonding station (6), which has channels (11) to which vacuum can be applied for sucking down the substrate (2).

3. Method according to claim 1, **characterised in that** the curing of the adhesive (4) takes place in an oven (19) separated from the bonding station (6).

4. Method according to claim 1 or 2 for equipping a substrate (2) which has substrate sites (5) arranged in blocks (16), **characterised in that** for the entire duration of equipping a block (16) the substrate (2) is fixed to the heating plate (9) by means of vacuum.

5. Apparatus for mounting semiconductor chips (1) onto a flexible substrate (2), with a dispensing station (3) for applying adhesive (4) to the substrate (2) and a bonding station (6) for equipping the substrate (2) with semiconductor chips (1), **characterised in that** a heating plate (9) is arranged after the bonding station (6) in a transport direction (8) of the substrate (2) which has channels (11) to which vacuum can be applied for sucking down the substrate (2).

6. Apparatus according to claim 5, **characterised in that** for the substrate (2) a support plate (12) is present which has channels (11) to which vacuum can be applied in order to fix the substrate (2) flat during application of the adhesive (4) and during placing of the semiconductor chips (1) and that the support plate (12) and the heating plate (9) are movable together in the transport direction (8) and at right angles to the transport direction (8).
